(19) Europäisches Patentamt
European Patent Office
Office européen des brevets

(11) **EP 3 485 626 B1**

(12) **FASCICULE DE BREVET EUROPEEN**

(45) Date de publication et mention de la délivrance du brevet:
**29.01.2020 Bulletin 2020/05**

(21) Numéro de dépôt: **17757798.8**

(22) Date de dépôt: **27.07.2017**

(51) Int Cl.:
*H04L 29/06* (2006.01)　　*H04B 7/185* (2006.01)
*H03J 7/02* (2006.01)　　*H04L 27/00* (2006.01)
*H04L 25/02* (2006.01)

(86) Numéro de dépôt international:
**PCT/FR2017/052110**

(87) Numéro de publication internationale:
**WO 2018/024968 (08.02.2018 Gazette 2018/06)**

(54) **PROCÉDÉ ET SYSTÈME DE DÉTECTION DE SIGNAUX UTILES À DÉRIVES FRÉQUENTIELLES RESPECTIVES NON NÉGLIGEABLES DANS UN SIGNAL GLOBAL**

VERFAHREN UND SYSTEM ZUR ERKENNUNG VON NÜTZLICHEN SIGNALEN MIT SIGNIFIKANTER ENTSPRECHENDER FREQUENZDRIFT BEI EINEM GESAMTSIGNAL

METHOD AND SYSTEM FOR DETECTING USEFUL SIGNALS WITH SIGNIFICANT RESPECTIVE FREQUENCY DRIFTS IN AN OVERALL SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.08.2016 FR 1657616**

(43) Date de publication de la demande:
**22.05.2019 Bulletin 2019/21**

(73) Titulaire: **Airbus Defence and Space SAS**
**31402 Toulouse Cedex 4 (FR)**

(72) Inventeurs:
• **GADAT, Benjamin**
**31402 Toulouse Cedex 04 (FR)**
• **BARTHE, Lyonel**
**31402 Toulouse Cedex 04 (FR)**
• **MAISONNAT, Thibault**
**31402 Toulouse Cedex 04 (FR)**
• **COLLIN, Arnaud**
**31402 Toulouse Cedex 04 (FR)**

(74) Mandataire: **Ipside**
**6, Impasse Michel Labrousse**
**31100 Toulouse (FR)**

(56) Documents cités:
WO-A1-2013/007613　　WO-A1-2014/006351
FR-A1- 2 992 506　　FR-A1- 2 995 115
FR-A1- 3 032 800　　US-B1- 8 406 353

EP 3 485 626 B1

## Description

### DOMAINE TECHNIQUE

La présente invention appartient au domaine de la détection de signaux utiles émis par différents terminaux. Plus particulièrement, la présente invention concerne la détection de signaux utiles dans le cas où chaque signal utile peut être affecté d'une dérive fréquentielle non négligeable, par exemple supérieure à une largeur spectrale dudit signal utile.

Par « largeur spectrale » du signal utile, on entend la largeur du spectre fréquentiel instantané du signal utile. La largeur spectrale dudit signal utile est donc indépendante de la dérive fréquentielle.

### ÉTAT DE LA TECHNIQUE

La présente invention trouve une application particulièrement avantageuse, bien que nullement limitative, dans le cas de signaux utiles dits à « bande étroite » pour lesquels la largeur spectrale est typiquement inférieure à 2 kilohertz, voire inférieure à 1 kilohertz.

Dans le cas de signaux utiles à bande étroite, de nombreux phénomènes peuvent introduire une dérive fréquentielle supérieure à la largeur spectrale desdits signaux utiles.

Tout d'abord, les signaux utiles étant reçus par une station de réception, des déplacements relatifs des terminaux par rapport à ladite station de réception peuvent induire, par effet Doppler, des dérives fréquentielles qui peuvent s'avérer non négligeables par rapport à la largeur spectrale des signaux utiles si les vitesses relatives de déplacement sont importantes. De telles dérives fréquentielles peuvent être introduites du fait d'une mobilité des terminaux et/ou d'une mobilité de la station de réception.

Notamment, dans le cas d'une station de réception embarquée dans un satellite en orbite défilante, par exemple une orbite basse LEO, la vitesse de défilement dudit satellite par rapport aux terminaux (fixes ou mobiles) peut introduire des dérives fréquentielles non négligeables des signaux utiles reçus au niveau de ladite station de réception.

La dérive fréquentielle peut également être introduite dès l'émission, de manière non contrôlée. En effet, l'émission d'un signal utile nécessite d'équiper un terminal de moyens de synthèse fréquentielle (oscillateur local, mélangeur, etc.) mis en œuvre pour translater en fréquences le signal utile, généré en bande de base, vers une bande fréquentielle de multiplexage des signaux utiles. De tels moyens de synthèse fréquentielle introduisent une dérive fréquentielle qui, dans le cas notamment de signaux utiles à bande étroite, peut s'avérer non négligeable par rapport à la largeur spectrale desdits signaux utiles, en particulier dans le cas de terminaux bas coût pour lesquels les moyens de synthèse fréquentielle sont peu performants. Cependant, la dérive fréquentielle introduite par les moyens de synthèse fréquentielle est faible au regard de celle engendrée par les déplacements relatifs des terminaux par rapport à la station de réception, en particulier sur une période courte telle que la durée d'un signa utile.

Dans une moindre mesure, les moyens de synthèse fréquentielle de la station de réception peuvent également introduire une dérive fréquentielle.

La détection de tels signaux utiles est complexe à effectuer, et ce d'autant plus que la dérive fréquentielle peut varier d'un signal utile à un autre. En outre, la fréquence de réception initiale et l'instant de réception de chaque signal utile ne sont pas nécessairement connus, ce qui rend la détection des signaux utiles encore plus complexe, puisqu'ils doivent être détectés de façon aveugle ou quasi-aveugle sans en connaître a priori les dérives fréquentielles, les instants de réception et les fréquences de réception initiales.

WO2014/006351 décrit un procédé de recherche de la présence d'un signal utile de largeur spectrale prédéfinie dans une bande de multiplexage de largeur spectrale supérieure à celle du signal.

Il est possible de mettre en œuvre des estimateurs au sens du maximum de vraisemblance, en testant toutes les possibilités possibles. Toutefois, la quantité de calculs à effectuer et la quantité de données à mémoriser est alors très importante, et peut s'avérer rédhibitoire, en particulier pour la détection de signaux utiles au niveau d'un satellite.

### EXPOSÉ DE L'INVENTION

La présente invention a pour objectif de remédier à tout ou partie des limitations des solutions de l'art antérieur, notamment celles exposées ci-avant, en proposant une solution qui permette de détecter des signaux utiles dans un signal global, lesdits signaux utiles pouvant être affectés de dérives fréquentielles de valeurs respectives différentes.

A cet effet, et selon un premier aspect, l'invention concerne un procédé de détection de signaux utiles dans un signal global, lesdits signaux utiles étant émis par différents terminaux dans une bande fréquentielle de multiplexage, chaque signal utile pouvant être affecté d'une dérive fréquentielle, le signal global correspondant aux signaux radioélectriques reçus dans la bande fréquentielle de multiplexage. Le procédé de détection de signaux utiles comporte une phase de détection suivie d'une phase d'estimation. La phase de détection comporte :

- pour plusieurs positions d'une fenêtre temporelle de détection par rapport au signal global : un calcul d'un spectre fréquentiel de détection du signal global sur chaque fenêtre temporelle de détection considérée,
- une détection de signaux utiles dans le signal global en fonction des spectres fréquentiels de détection.

La phase d'estimation comporte ensuite, pour chaque signal utile détecté dans le signal global :

- pour plusieurs valeurs de dérive fréquentielle : un recalage en fréquences du signal global en fonction de la valeur de dérive fréquentielle considérée,
- un calcul d'un spectre fréquentiel d'estimation du signal global pour chaque valeur de dérive fréquentielle sur une fenêtre temporelle d'estimation comportant au moins une partie dudit signal utile détecté, de durée supérieure à la durée de la fenêtre temporelle de détection,
- une estimation de la dérive fréquentielle affectant ledit signal utile détecté en fonction des spectres fréquentiels d'estimation.

Ainsi, le procédé de détection comporte principalement deux phases, une phase de détection et une phase d'estimation. La phase de détection vise à détecter les signaux utiles présents dans le signal global, ainsi que leurs positions temporelles respectives dans ledit signal global. Une fois les signaux utiles détectés, la phase d'estimation vise alors, notamment, à estimer les dérives fréquentielles affectant lesdits signaux utiles détectés.

La phase de détection et la phase d'estimation reposent toutes deux sur le calcul de plusieurs spectres fréquentiels du signal global.

Au cours de la phase de détection, on calcule plusieurs spectres fréquentiels de détection du signal global sur des fenêtres temporelles de détection respectives décalées temporellement les unes par rapport aux autres, afin de déterminer les positions temporelles respectives des signaux utiles dans le signal global.

Au cours de la phase d'estimation, on calcule, pour chaque signal utile détecté, plusieurs spectres fréquentiels d'estimation du signal global associés respectivement à différentes valeurs de dérive fréquentielle avec lesquelles ledit signal global est recalé en fréquences. Par contre, pour chaque signal utile détecté, les spectres fréquentiels d'estimation sont calculés sur une seule et même fenêtre temporelle d'estimation, positionnée par rapport au signal global au niveau dudit signal utile détecté.

La durée de la fenêtre temporelle de détection est choisie inférieure, voire très inférieure à la durée de la fenêtre temporelle d'estimation. De telles dispositions sont avantageuses pour plusieurs raisons.

Tout d'abord, étant donné que la phase de détection vise à détecter les signaux utiles et leurs positions temporelles, et non à estimer leurs dérives fréquentielles, la durée de la fenêtre temporelle de détection peut être choisie de telle sorte que la variation fréquentielle introduite par la dérive fréquentielle au cours de la fenêtre temporelle de détection est négligeable, ce qui simplifie la détection des signaux utiles. En outre, la quantité de calculs nécessaires pour obtenir les spectres fréquentiels de détection diminue avec la durée de la fenêtre temporelle de détection. La résolution fréquentielle des spectres fréquentiels de détection diminue également avec ladite durée, mais les besoins en termes de résolution fréquentielle au cours de la phase de détection sont limités, dans la mesure où celle-ci vise principalement à détecter les signaux utiles et leurs positions temporelles dans le signal global.

Au cours de la phase d'estimation, on considère donc une fenêtre temporelle d'estimation de durée supérieure à celle de la fenêtre temporelle de détection, de sorte que la variation fréquentielle, introduite par la dérive fréquentielle au cours d'une fenêtre temporelle d'estimation, n'est pas négligeable et permet donc d'observer et d'estimer ladite dérive fréquentielle. La quantité de calculs nécessaires pour obtenir un spectre fréquentiel d'estimation est supérieure à celle nécessaire pour obtenir un spectre fréquentiel de détection. Toutefois, étant donné que les signaux utiles et leurs positions temporelles ont été préalablement détectés au cours de la phase de détection, le nombre de spectres fréquentiels d'estimation à calculer est avantageusement réduit au strict minimum nécessaire pour estimer la dérive fréquentielle de chaque signal utile détecté. En outre, en considérant une fenêtre temporelle d'estimation de durée plus importante, la résolution fréquentielle est améliorée, ce qui permet d'estimer la dérive fréquentielle de chaque signal utile avec une bonne précision.

Dans des modes particuliers de mise en œuvre, le procédé de détection peut en outre comporter l'une ou plusieurs des caractéristiques suivantes, prises isolément ou selon toutes les combinaisons techniquement possibles.

Dans des modes particuliers de mise en œuvre, chaque signal utile comporte un motif de détection et :

- le calcul de spectre fréquentiel de détection comporte, pour chaque fenêtre temporelle de détection, une combinaison du signal global avec un motif de détection de référence positionné au niveau de la fenêtre temporelle de détection considérée,
- le calcul de spectre fréquentiel d'estimation comporte, pour chaque valeur de dérive fréquentielle, une combinaison du signal global avec le motif de détection de référence positionné au niveau de la fenêtre temporelle d'estimation.

Dans des modes particuliers de mise en œuvre, la combinaison du signal global avec le motif de détection de référence comporte une corrélation dudit signal global avec ledit motif de détection de référence.

Dans des modes particuliers de mise en œuvre, la durée de la fenêtre temporelle de détection est inférieure à la durée du motif de détection.

Dans des modes particuliers de mise en œuvre, le procédé de détection comporte :

- au cours de la phase de détection : une estimation d'une fréquence de réception de chaque signal utile détecté dans la bande de multiplexage, en fonction des spectres fréquentiels de détection,

- au cours de la phase d'estimation, pour chaque signal utile détecté : le recalage en fréquences du signal global en fonction de la fréquence de réception estimée dudit signal utile détecté.

Dans des modes particuliers de mise en œuvre, le procédé de détection comporte, au cours de la phase d'estimation, une estimation d'une fréquence de réception de chaque signal utile détecté dans la bande de multiplexage, en fonction des spectres fréquentiels d'estimation.

Dans des modes particuliers de mise en œuvre, la détection de signaux utiles comporte la recherche de maxima locaux dans les spectres fréquentiels de détection, un signal utile étant considéré comme détecté pour un maximum local si ledit maximum local vérifie un critère prédéterminé de détection.

Dans des modes particuliers de mise en œuvre, l'estimation de dérive fréquentielle affectant l'un des signaux utiles détectés comporte la recherche d'un maximum global dans les spectres fréquentiels d'estimation calculés pour ledit signal utile détecté.

Dans des modes particuliers de mise en œuvre, au cours de l'estimation de dérive fréquentielle, le maximum global est recherché parmi les valeurs des spectres fréquentiels d'estimation obtenues dans une bande de fréquences de largeur prédéterminée autour d'une fréquence théorique de réception du signal utile détecté considéré.

Dans des modes particuliers de mise en œuvre, le procédé de détection comporte une estimation du nombre de signaux utiles à détecter dans le signal global, et la détection de signaux utiles est effectuée en fonction dudit nombre estimé de signaux utiles à détecter.

Dans des modes particuliers de mise en œuvre, le procédé de détection comporte une estimation d'une plage de valeurs possibles pour la dérive fréquentielle, les valeurs de dérive fréquentielle considérées au cours de la phase d'estimation étant comprises dans ladite plage de valeurs possibles.

Selon un second aspect, la présente invention concerne un produit programme d'ordinateur comportant un ensemble d'instructions de code de programme qui, lorsqu'elles sont exécutées par un processeur, configurent ledit processeur pour mettre en œuvre un procédé de détection de signaux utiles dans un signal global selon l'un quelconque des modes de mise en œuvre de l'invention.

Selon un troisième aspect, la présente invention concerne un module de détection de signaux utiles dans un signal global comportant des moyens configurés pour mettre en œuvre un procédé selon l'un quelconque des modes de mise en œuvre de l'invention.

Dans des modes particuliers de réalisation, le module de détection peut en outre comporter l'une ou plusieurs des caractéristiques suivantes, prises isolément ou selon toutes les combinaisons techniquement possibles.

Dans des modes particuliers de réalisation, le module de détection comporte une architecture de traitement de type pipeline.

Dans des modes particuliers de réalisation, le module de détection comporte un premier ensemble d'unités de calcul utilisées uniquement pour la phase de détection et un second ensemble d'unités de calcul utilisées uniquement pour la phase d'estimation.

Selon un quatrième aspect, la présente invention concerne un système de détection de signaux utiles dans un signal global, comportant une antenne de réception du signal global embarquée dans un engin spatial ou aérien, et comportant en outre un module de détection selon l'un quelconque des modes de réalisation de l'invention.

Dans des modes particuliers de réalisation du système de détection, le module de détection est embarqué dans l'engin spatial ou aérien.

## PRÉSENTATION DES FIGURES

L'invention sera mieux comprise à la lecture de la description suivante, donnée à titre d'exemple nullement limitatif, et faite en se référant aux figures qui représentent :

- Figure 1 : une représentation schématique d'un exemple de réalisation d'un système de détection de signaux utiles,
- Figure 2 : un diagramme représentant les principales étapes d'un procédé de détection de signaux utiles selon l'invention,
- Figure 3 : un diagramme représentant les principales étapes d'une première variante du procédé de détection de la figure 2,
- Figure 4 : un diagramme représentant les principales étapes d'une seconde variante du procédé de détection de la figure 2.
- Figure 5 : une représentation schématique d'une architecture de traitement séquentiel de données,
- Figure 6 : une représentation schématique d'une architecture de traitement en pipeline de données,
- Figure 7 : une représentation schématique d'une variante de l'architecture de traitement en pipeline de la figure 6,
- Figure 8 : une représentation schématique d'une architecture de traitement en pipeline pour les différentes phases du procédé de détection de la figure 2.

Dans ces figures, des références identiques d'une figure à une autre désignent des éléments identiques ou analogues. Pour des raisons de clarté, les éléments représentés ne sont pas à l'échelle, sauf mention contraire.

## DESCRIPTION DÉTAILLÉE DE MODES DE RÉALISATION

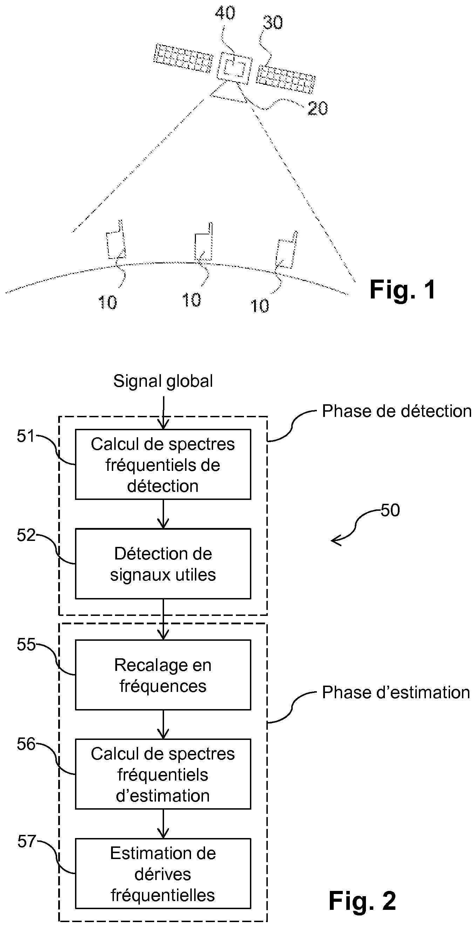

La figure 1 représente schématiquement un exemple de réalisation d'un système de détection de signaux utiles. Les signaux utiles correspondent à des signaux radioélectriques émis dans une bande fréquentielle de multiplexage par des terminaux 10 sensiblement à la surface de la Terre. Par « sensiblement à la surface de la Terre », on entend que chaque terminal 10 est au sol (terrestre ou maritime), ou bien en altitude dans l'atmosphère terrestre (embarqué dans un avion, un drone, un ballon, etc.).

Plus particulièrement, les signaux utiles doivent être détectés dans un signal global, reçu par une station de réception 20, représentatif de l'ensemble des signaux radioélectriques mesurés dans la bande fréquentielle de multiplexage. Il est à noter que l'invention est applicable dans n'importe quelle bande de fréquences, notamment les bandes de fréquences traditionnellement utilisées dans les systèmes de télécommunications terrestres ou par satellite.

Dans la suite de la description, et tel qu'illustré par la figure 1, on se place de manière non limitative dans le cas où la station de réception 20 est embarquée dans un satellite 30 en orbite terrestre. Rien n'exclut cependant, suivant d'autres exemples, d'avoir une station de réception embarquée dans un engin spatial ou aérien (avion, drone, ballon, etc.). La station de réception peut également, suivant d'autres exemples, être au sol (terrestre ou maritime).

Le satellite 30 est de préférence en orbite basse altitude LEO (« Low Earth Orbit »). Rien n'exclut cependant de considérer d'autres types d'orbites, par exemple une orbite moyenne altitude MEO (« Médium Earth Orbit »), une orbite géostationnaire GEO (« Geostationary Orbit »), etc.

Chaque terminal 10 peut être fixe ou mobile. De même, la station de réception 20 peut être fixe ou mobile.

Tel qu'indiqué précédemment, chaque signal utile reçu par la station de réception 20 peut être affecté d'une dérive fréquentielle. Dans la suite de la description, on se place de manière non limitative dans le cas où la dérive fréquentielle est supérieure à la largeur spectrale dudit signal utile. Par « largeur spectrale » du signal utile, on entend la largeur du spectre fréquentiel instantané du signal utile.

La bande fréquentielle de multiplexage est de préférence de largeur très supérieure à la largeur spectrale de chaque signal utile, par exemple au moins 100 fois supérieure à la largeur spectrale maximale des signaux utiles. Le signal global, représentatif des signaux radioélectriques mesurés dans la bande fréquentielle de multiplexage, peut par conséquent comporter de nombreux signaux utiles multiplexés en fréquences dans ladite bande fréquentielle de multiplexage. En outre, les signaux utiles étant de durée finie, le signal global peut également comporter de nombreux signaux utiles répartis au cours du temps. Dans la suite de la description, on se place de manière non limitative dans le cas où la station de réception 20 ne connaît pas a priori :

- les instants de réception respectifs des signaux utiles, par exemple du fait que les terminaux peuvent émettre quand ils le souhaitent, sans autorisation préalable, ou émettent à des instants choisis aléatoirement pour réduire les risques de collision entre signaux utiles, etc.,
- les fréquences de réception initiales respectives desdits signaux utiles, par exemple du fait que les terminaux peuvent émettre sur la fréquence qu'ils souhaitent à l'intérieur de la bande fréquentielle de multiplexage, ou ne maîtrisent pas parfaitement la fréquence sur laquelle ils émettent (par exemple du fait de moyens de synthèse fréquentielle peu performants), etc.

Dans la suite de la description, on se place de manière non limitative dans le cas où les signaux utiles sont à bande étroite, c'est-à-dire de largeur spectrale égale ou inférieure à 2 kilohertz, de préférence égale ou inférieure à 1 kilohertz. L'invention est également applicable pour d'autres types de signaux utiles, toutefois on comprend que, pour de tels signaux utiles, une dérive fréquentielle peut facilement devenir non négligeable.

Tel qu'illustré par la figure 1, le système de détection de signaux utiles comporte également un module 40 de détection.

Dans l'exemple non limitatif illustré par la figure 1, le module 40 de détection est embarqué dans le satellite 30. Rien n'exclut, suivant d'autres exemples, d'avoir un module 40 de détection distant du satellite 30, par exemple au niveau d'une station sol (non représentée sur les figures), ou distribué entre le satellite 30 et un ou plusieurs équipements distants dudit satellite 30. A des fins de redondance, le système de détection peut comporter un module 40 de détection embarqué à bord du satellite 30, et un autre module 40 de détection au niveau d'une ou de plusieurs stations sol.

Le module 40 de détection est adapté notamment à détecter des signaux utiles dans le signal global reçu par la station de réception 20, ledit signal global se présentant sous la forme d'une suite d'échantillons obtenus après conversion analogique / numérique d'un signal analogique fourni par ladite station de réception 20.

Le module 40 de détection comporte par exemple un circuit de traitement comportant un ou plusieurs processeurs et des moyens de mémorisation (disque dur magnétique, mémoire électronique, disque optique, etc.) dans lesquels est mémorisé un produit programme d'ordinateur, sous la forme d'un ensemble d'instructions de code de programme à exécuter pour mettre en œuvre tout ou partie des étapes d'un procédé 50 de détection de signaux utiles dans le signal global. Alternativement ou en complément, le circuit de traitement comporte un ou des circuits logiques programmables (FPGA, PLD, etc.), et/ou un ou des circuits intégrés spécialisés (ASIC), et/ou un ensemble de composants électroniques discrets, etc. adaptés à mettre en œuvre tout ou partie des étapes du procédé 50 de détection de signaux utiles.

En d'autres termes, le circuit de traitement correspond à un ensemble de moyens configurés de façon logicielle (produit programme d'ordinateur spécifique) et/ou matérielle (FPGA, PLD, ASIC, etc.) pour mettre en œuvre les différentes étapes du procédé 50 de détection de signaux utiles.

Le procédé 50 de détection selon invention se révèle particulièrement efficace pour être mis en œuvre sur des technologies de type ASIC ou FPGA permettant d'exploiter le parallélisme matériel et ainsi de réduire la complexité, le coût et l'encombrement de la solution matérielle.

En effet, la structure globale du procédé 50 de détection permet la mise en place d'une architecture de traitement en pipeline, réalisant les différentes étapes du procédé 50 de détection en parallèle, tout en favorisant la réutilisation de ressources matérielles. Une telle architecture de traitement en pipeline est bien plus avantageuse qu'une architecture de traitement séquentiel qui donnerait lieu à une solution moins optimisée car utilisant de manière moins efficace les ressources matérielles disponibles.

La figure 2 représente les principales étapes d'un procédé 50 de détection de signaux utiles dans le signal global. Tel qu'illustré par la figure 2, le procédé 50 de détection comporte principalement deux phases :

- une phase de détection visant principalement à détecter les signaux utiles présents dans le signal global, ainsi que leurs positions temporelles dans ledit signal global,
- une phase d'estimation visant principalement à estimer les dérives fréquentielles respectives des signaux utiles détectés au cours de la phase de détection.

La phase de détection est donc exécutée avant la phase d'estimation, étant donné que la phase d'estimation s'appuie sur les signaux utiles détectés au cours de la phase de détection. De préférence, la phase d'estimation est donc exécutée après la fin de la phase de détection. Toutefois, rien n'exclut d'exécuter la phase d'estimation avant la fin de la phase de détection. En effet, la phase d'estimation peut être exécutée dès qu'un signal utile est détecté au cours de la phase de détection, pour en estimer la dérive fréquentielle, sans avoir à attendre d'avoir détecté tous les signaux utiles dans le signal global.

Tel qu'illustré par la figure 2, la phase de détection comporte :

- pour plusieurs positions d'une fenêtre temporelle de détection par rapport au signal global : une étape 51 de calcul d'un spectre fréquentiel de détection du signal global sur chaque fenêtre temporelle de détection considérée,
- une étape 52 de détection de signaux utiles dans le signal global en fonction des spectres fréquentiels de détection.

La phase d'estimation comporte, pour chaque signal utile détecté :

- pour plusieurs valeurs de dérive fréquentielle : une étape 55 de recalage en fréquences du signal global en fonction de la valeur de dérive fréquentielle considérée,
- une étape 56 de calcul d'un spectre fréquentiel d'estimation du signal global pour chaque valeur de dérive fréquentielle sur une fenêtre temporelle d'estimation comportant au moins une partie dudit signal utile détecté, de durée supérieure à la durée de la fenêtre temporelle de détection,
- une étape 57 d'estimation de la dérive fréquentielle affectant ledit signal utile détecté en fonction des spectres fréquentiels d'estimation.

Dans la suite de la description, on se place de manière non limitative dans le cas où chaque signal utile à détecter comporte un motif de détection prédéterminé, connu a priori du module 40 de détection ou pouvant être déterminée par celui-ci avant la détection. Par exemple, le motif de détection correspond à une information connue a priori du module 40 de détection, placée au début (« preamble » dans la littérature anglo-saxonne), et/ou au milieu (« middamble » dans la littérature anglo-saxonne) et/ou à la fin (« postamble » dans la littérature anglo-saxonne) dudit signal utile. Dans un tel cas, le module 40 de détection peut mémoriser un motif de détection de référence correspondant au motif de détection inséré dans chaque signal utile par chaque terminal 10, et peut exploiter la présence de ce motif de détection dans chaque signal utile pour améliorer la détection. Par exemple, dans des modes préférés de mise en œuvre du procédé 50 de détection :

- l'étape 51 de calcul de spectre fréquentiel de détection comporte, pour chaque fenêtre temporelle de détection, une combinaison du signal global avec tout ou partie dudit motif de détection de référence positionné au niveau de la fenêtre temporelle de détection considérée, et
- l'étape 56 de calcul de spectre fréquentiel d'estimation comporte, pour chaque valeur de dérive fréquentielle, une combinaison du signal global avec tout ou partie dudit motif de détection de référence positionné au niveau de la fenêtre temporelle d'estimation.

En effet, en combinant le signal global avec le motif de détection de référence, par exemple en effectuant une corrélation dudit signal global avec ledit motif de détection de référence, cela permet d'améliorer le rapport signal utile sur bruit lorsque le motif de détection de référence est sensiblement superposé au motif de détection inclus dans un signal utile, et donc d'améliorer la détection dudit signal utile.

Il est cependant à noter que, suivant d'autres exemples non détaillés dans la suite de la description, l'invention peut également être mise en œuvre en l'absence de motif de détection. En particulier, dans le cas de signaux utiles à bande étroite, le spectre fréquentiel instantané de chaque signal utile est très resserré en fréquences et forme en principe un pic caractéristique qui peut être détecté par une analyse spectrale, sans utiliser de connaissance a priori d'un motif de détection inclus dans les signaux utiles.

Dans le cas, considéré ci-après, où on utilise une connaissance a priori d'un motif de détection inclus dans chaque signal utile, la durée de la fenêtre temporelle de détection est par exemple inférieure à la durée dudit motif de détection, voire très inférieure à celle-ci (au moins un facteur cinq), afin d'assurer que la variation fréquentielle, induite par la dérive fréquentielle au cours de ladite fenêtre temporelle de détection, est négligeable.

On décrit à présent des exemples détaillés de mise en œuvre des différentes étapes de la phase de détection et de la phase d'estimation.

A) Phase de détection

A.1) Calcul de spectre fréquentiel de détection

Tel qu'indiqué précédemment, la phase de détection comporte, pour plusieurs positions d'une fenêtre temporelle de détection par rapport au signal global, une étape 51 de calcul d'un spectre fréquentiel de détection du signal global sur chaque fenêtre temporelle de détection considérée. On se place en outre, de manière non limitative, dans le cas où le signal global est combiné avec un motif de détection de référence.

Le signal global se présente sous la forme d'une suite d'échantillons obtenus après conversion analogique / numérique d'un signal analogique fourni par la station de réception 20. Par exemple, le signal global comporte un nombre $N_{ACQ}$ d'échantillons x[j] ($0 \leq j \leq N_{ACQ}$-1) séparés par une période d'échantillonnage Te prédéfinie.

Pour calculer un spectre fréquentiel de détection, on considère uniquement les échantillons du signal global compris dans une fenêtre temporelle de détection de durée δT prédéterminée, et on calcule des spectres fréquentiels de détection pour différentes positions temporelles de ladite fenêtre temporelle de détection par rapport au signal global. Dans la suite de la description, on se place dans le cas où chaque fenêtre temporelle de détection comporte $N_{DET}$ échantillons du signal global (δT = $N_{DET}$·Te). Le nombre de positions temporelles différentes considérées dépend de la précision souhaitée pour l'estimation de l'instant de réception d'un signal utile.

Dans la suite de la description, on se place, à titre d'exemple non limitatif, dans le cas où les différentes positions temporelles considérées sont espacées de la période d'échantillonnage Te. Ainsi, la fenêtre temporelle de détection positionnée au niveau de l'instant de rang k comporte les $N_{DET}$ échantillons x[k] à x[k+$N_{DET}$-1], et on désigne par $x_k$ le vecteur comportant ces $N_{DET}$ échantillons :

$$x_k = \{x[k+n], 0 \leq n \leq N_{DET}\text{-}1\}$$

Dans un tel cas, il est possible de considérer $N_{FEN}$ positions temporelles différentes pour la fenêtre temporelle de détection, $N_{FEN}$ étant égal à ($N_{ACQ}$ - $N_{DET}$ + 1).

Le motif de détection de référence, qui correspond au motif de détection inclus dans un signal utile, est désigné par $p_{REF}$ et comporte $N_{REF}$ échantillons $p_{REF}[0]$ à $p_{REF}[N_{REF}\text{-}1]$. Dans l'exemple décrit ci-après, $N_{REF}$ est considéré de manière nullement limitative comme étant supérieur au nombre $N_{DET}$ d'échantillons de la fenêtre temporelle de détection.

Tel qu'indiqué précédemment, l'étape 51 de calcul de spectre fréquentiel de détection comporte préférentiellement, pour chaque fenêtre temporelle de détection, une combinaison du signal global avec le motif de détection de référence positionné au niveau de la fenêtre temporelle de détection considérée. Etant donné que $N_{REF}$ est supérieur à $N_{DET}$, seule une partie des échantillons du motif de détection de référence $p_{REF}$, par exemple formée par les $N_{DET}$ premiers échantillons dudit motif de détection de référence, est combinée avec le signal global $x_k$ sur la fenêtre temporelle de détection positionnée au niveau de l'instant de rang k. La combinaison correspond par exemple à une corrélation du signal global $x_k$ avec le motif de détection de référence, auquel cas le signal global $x'_k$ obtenu après combinaison correspond par exemple au vecteur suivant :

$$x'_k = \{x[k+n] \cdot p_{REF}[n]^*, 0 \leq n \leq N_{DET}\text{-}1\}$$

expression dans laquelle z* correspond au conjugué du nombre complexe z.

Le spectre fréquentiel de détection du signal global $x'_k$ obtenu après combinaison sur la fenêtre temporelle de détection positionnée au niveau de l'instant de rang k est désigné par $SD_k$. Le spectre fréquentiel de détection $SD_k$ est par exemple calculé par transformée de Fourier rapide ou FFT (« Fast Fourier Transform » dans la littérature anglo-saxonne) du signal global $x'_k$, auquel cas :

$$SD_k = FFT(x'_k)$$

Il est à noter que la combinaison peut être calculée indifféremment dans le domaine temporel ou dans le domaine fréquentiel. En particulier, ladite combinaison peut être effectuée dans le domaine temporel, avant le calcul du spectre fréquentiel de détection $SD_k$, ou après passage dans le domaine fréquentiel, en combinant le spectre fréquentiel du motif de détection de référence avec le spectre fréquentiel de détection $SD_k$.

Ainsi, à l'issue de l'étape 51 de calcul, on dispose par exemple de $N_{FEN}$ spectres fréquentiels de détection $SD_k$ associés respectivement aux $N_{FEN}$ différentes positions temporelles considérées de la fenêtre temporelle de détection par rapport au signal global ($0 \leq k \leq N_{FEN}-1$).

A.2) Détection de signaux utiles

Tel qu'indiqué ci-dessus, la phase de détection comporte en outre une étape 52 de détection de signaux utiles dans le signal global en fonction des spectres fréquentiels de détection $SD_k$ calculés.

Dans des modes préférés de mise en œuvre, l'étape 52 de détection comporte la recherche de maxima locaux dans les spectres fréquentiels de détection $SD_k$. En effet, la présence d'un signal utile dans le signal global se traduira généralement par la présence d'un pic dans le spectre fréquentiel de détection calculé pour la fenêtre temporelle de détection positionnée au niveau de ce signal utile. On comprend donc que la recherche de maxima locaux doit permettre de retrouver les signaux utiles reçus dans le signal global. Un signal utile est alors considéré comme détecté pour un maximum local si ledit maximum local vérifie un critère prédéterminé de détection. Par exemple, le critère de détection est considéré comme vérifié pour un maximum local d'un spectre fréquentiel de détection $SD_k$ si ledit maximum local est supérieur à une valeur seuil prédéterminée et/ou si ledit maximum local fait partie des Np maxima locaux les plus importants identifiés sur tous les $N_{FEN}$ spectres fréquentiels de détection, $N_P$ étant un nombre prédéterminé de signaux utiles à détecter dans le signal global, etc.

De préférence, la recherche de maxima locaux dans un spectre fréquentiel de détection $SD_k$ ne retient que des maxima locaux espacés d'un intervalle fréquentiel de garde de largeur fréquentielle prédéterminée. De telles dispositions permettent de limiter la probabilité de fausse détection. En effet, deux maxima locaux très proches correspondront en général au même signal utile, et la prise en compte d'un tel intervalle fréquentiel de garde permet donc d'éviter de détecter plusieurs signaux utiles là où il n'y a probablement qu'un seul signal utile. Pour des signaux utiles à bande étroite, la largeur fréquentielle de l'intervalle fréquentiel de garde est par exemple de l'ordre de 50Hz.

• Pour les mêmes raisons, il est également possible de prévoir un nombre maximal $N_{MAX}$ de maxima locaux pouvant être détectés dans chaque spectre fréquentiel de détection $SD_k$, le nombre $N_{MAX}$ étant le cas échéant égal ou inférieur à $N_P$.

Le nombre Np de signaux utiles à détecter dans le signal global est par exemple un nombre prédéfini, invariant au cours du temps. Suivant d'autres exemples, le nombre $N_P$ de signaux utiles à détecter dans le signal global peut varier au cours du temps. Le cas échéant, le nombre $N_P$ est par exemple estimé par le module 40 de détection en effectuant une analyse statistique du signal global, et/ou en prenant en compte un modèle de densité de terminaux 10 dans les zones géographiques survolées par le satellite 30, etc. Il est également possible de tenir compte, pour estimer le nombre $N_P$ de signaux utiles à détecter, des signaux utiles détectés au cours d'exécutions précédentes du procédé 50 de détection. En effet, le nombre $N_P$ peut être initialement volontaire surdimensionné afin de réduire la probabilité de manquer un signal utile présent dans le signal global. Après avoir détecté un signal utile, des étapes de démodulation, qui sortent du cadre de l'invention, sont généralement exécutées pour extraire les données incluses dans ledit signal utile détecté. Ces étapes de démodulation permettent alors de vérifier si le signal détecté correspond bien à un signal utile émis par un terminal 10. Dans le cas contraire, le nombre Np de signaux utiles à détecter est actualisé pour tenir compte des signaux détectés qui se sont avérés, in fine, ne pas être des signaux utiles émis par des terminaux 10.

A l'issue de l'étape 52 de détection, on a donc détecté $N_P$ signaux utiles. Pour chaque signal utile détecté, le spectre fréquentiel de détection $SD_k$ dans lequel le maximum local correspondant a été détecté permet en outre d'estimer l'instant de réception dudit signal utile. En effet, l'instant de réception $T_m$ ($0 \leq m \leq N_P-1$) dudit signal utile détecté peut par exemple être estimé comme étant la position temporelle (instant de rang k) de la fenêtre temporelle de détection associée au spectre fréquentiel de détection $SD_k$ ayant conduit à détecter ce signal utile.

A.3) Estimation de la fréquence de réception de signal utile détecté

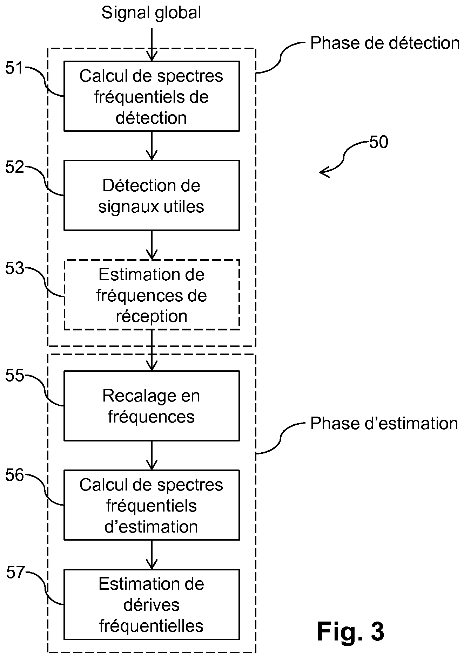

La figure 3 représente les principales étapes d'un mode particulier de mise en œuvre du procédé 50 de détection.

Tel qu'illustré par la figure 3, la phase de détection du procédé 50 de détection comporte, outre les étapes décrites précédemment en référence à la figure 2, une étape 53 d'estimation d'une fréquence de réception $F_m$ ($0 \leq m \leq N_P-1$) de chaque signal utile détecté, en fonction des spectres fréquentiels de détection $SD_k$. La fréquence de réception $F_m$ ($0 \leq m \leq N_P-1$) dudit signal utile détecté peut par exemple être estimée comme étant la fréquence discrète pour laquelle le maximum local, associé audit signal utile détecté, a été obtenu dans le spectre fréquentiel de détection $SD_k$ ayant conduit à dé-

tecter ce signal utile.

### B) Phase d'estimation

Tel qu'indiqué précédemment, la phase d'estimation comporte plusieurs étapes qui sont exécutées pour chaque signal utile détecté au cours de la phase de détection. Dans la suite de la description, on décrit ces étapes en considérant uniquement un seul signal utile détecté, étant entendu que lesdites étapes sont en pratique exécutées pour chaque signal utile détecté.

### B.1) Recalage en fréquences du signal global

Tel qu'indiqué précédemment, la phase d'estimation comporte une étape 55 de recalage en fréquences du signal global pour plusieurs valeurs de dérive fréquentielle.

Le signal global est de préférence recalé en fréquences principalement sur une fenêtre temporelle d'estimation positionnée au niveau du signal utile détecté, de durée $\Delta T$ prédéterminée supérieure à la durée $\delta T$ de la fenêtre temporelle de détection. Dans la suite de la description, on se place dans le cas où la fenêtre temporelle d'estimation comporte $N_{EST}$ échantillons du signal global ($\Delta T = N_{EST} \cdot Te$). Par exemple, le nombre $N_{EST}$ est égal au nombre $N_{REF}$ d'échantillons du motif de détection de référence.

La fenêtre temporelle d'estimation est positionnée, par rapport au signal global, de sorte à comporter au moins une partie du signal utile détecté, et en particulier du motif de détection dudit signal utile détecté. Par exemple, la fenêtre temporelle d'estimation débute à l'instant de réception $T_m$ estimé, et comporte les $N_{EST}$ échantillons $x[T_m]$ à $x[T_m+N_{EST}-1]$ du signal global, et on désigne par $xe_m$ le vecteur comportant ces $N_{EST}$ échantillons :

$$xe_m = \{xe_m[n] = x[T_m+n],\ 0 \leq n \leq N_{EST}-1\}$$

Sur cette fenêtre temporelle d'estimation au moins, le signal global est recalé en fonction de plusieurs valeurs de dérive fréquentielle, qui correspondent à des valeurs possibles de la dérive fréquentielle affectant le signal utile détecté.

Les différentes valeurs de dérive fréquentielle à considérer sont par exemple choisies réparties de manière régulière dans un plage prédéterminée de valeurs possibles, dont les bornes sont par exemple définies en fonction d'une connaissance a priori des dérives fréquentielles maximales susceptibles d'affecter les différents signaux utiles (par exemple en fonction des vitesses maximales de déplacement des terminaux 10 et de la station de réception 20, en fonction de la dérive fréquentielle maximale des moyens de synthèse fréquentielle des terminaux 10, etc.). La plage de valeurs possibles pour la dérive fréquentielle peut être prédéfinie, invariante au cours du temps. Suivant d'autres exemples, la plage de valeurs possibles pour la dérive fréquentielle peut varier au cours du temps, et être par exemple actualisée en tenant compte des dérives fréquentielles estimées pour des signaux utiles détectés au cours d'exécutions précédentes du procédé 50 de détection.

La plage de valeurs possibles comporte un nombre $N_{DER}$ de valeurs $\alpha_j$ ($0 \leq j \leq N_{DER}-1$) de dérive fréquentielle. Par exemple, le nombre $N_{DER}$ est égal à 11, et les valeurs $\alpha_j$ de dérive fréquentielle sont comprises entre -500 hertz par seconde (Hz/s) et 0 Hz/s, avec un pas de 50 Hz/s :

$$\alpha_j \in \{-500, -450, \ldots, -50, 0\}\ \text{Hz/s}$$

Le signal global recalé en fréquences par la valeur $\alpha_j$ de dérive fréquentielle, désigné par $r_j = \{r_j[n], 0 \leq j \leq N_{EST}-1\}$, est par exemple calculé selon l'expression suivante :

$$r_j[n] = xe_m[n] \cdot e^{-j \cdot \pi \cdot \alpha_j \cdot (n \cdot Te)^2}$$

expression dans laquelle :

-   j est l'unité imaginaire ($j^2 = -1$),
-   $e^{(z)}$ est la fonction exponentielle de la valeur z.

Dans le cas où la fréquence de réception $F_m$ du signal utile détecté a également été estimée au cours de la phase de détection, alors le signal global est de préférence recalé en fréquences en fonction en outre de ladite fréquence de réception $F_m$ estimée, par exemple selon l'expression suivante :

$$r_j[n] = xe_m[n] \cdot e^{-j \cdot \pi \cdot \left(\alpha_j \cdot (n \cdot Te)^2 + 2 \cdot F_m \cdot n \cdot Te\right)}$$

### B.2) Calcul de spectre fréquentiel d'estimation

La phase d'estimation comporte une étape 56 de calcul d'un spectre fréquentiel d'estimation du signal global $r_j$ ($0 \leq j \leq N_{DER}-1$) pour chaque valeur $\alpha_j$ de dérive fréquentielle considérée, sur la fenêtre temporelle d'estimation.

Tel qu'indiqué précédemment, l'étape 56 de calcul de spectre fréquentiel d'estimation comporte préférentiellement une combinaison du signal global avec le motif de détection de référence positionné au niveau de la fenêtre temporelle d'estimation. La combinaison correspond par exemple à une corrélation du signal global $r_j$ avec le motif de détection de référence, auquel cas le signal global $r'_j$ obtenu après combinaison correspond par exemple au vecteur suivant :

$$r'_j = \{r_j[n] \cdot p_{REF}[n]^*, 0 \le n \le N_{EST}-1\}$$

Le spectre fréquentiel d'estimation du signal global $r'_j$ obtenu après combinaison sur la fenêtre temporelle d'estimation est désigné par $SE_j$. Le spectre fréquentiel d'estimation $SE_j$ est par exemple calculé par FFT du signal global $r'_j$, auquel cas :

$$SE_j = FFT(r'_j)$$

Il est à noter que la combinaison peut être calculée indifféremment dans le domaine temporel ou dans le domaine fréquentiel. En particulier, ladite combinaison peut être effectuée dans le domaine temporel, avant le calcul du spectre fréquentiel d'estimation $SE_j$, ou après passage dans le domaine fréquentiel, en combinant le spectre fréquentiel du motif de détection de référence avec le spectre fréquentiel d'estimation $SE_j$.

En outre, il est à noter que l'étape 55 de recalage en fréquences peut être indifféremment exécutée avant l'étape 56 de calcul de spectre fréquentiel d'estimation, ou après ladite étape 56 de calcul de spectre fréquentiel d'estimation, ou encore simultanément à celle-ci. Il est d'ailleurs à noter que le recalage en fréquences du signal global peut être indifféremment effectué dans le domaine temporel ou dans le domaine fréquentiel.

Ainsi, à l'issue de l'étape 56 de calcul, on dispose par exemple, pour chaque signal utile détecté, de $N_{DER}$ spectres fréquentiels d'estimation $SE_j$ associés respectivement aux $N_{DER}$ différentes valeurs $\alpha_j$ de dérive fréquentielle considérées ($0 \le j \le N_{DER}-1$).

B.3) Estimation de dérive fréquentielle

Tel qu'indiqué ci-dessus, la phase d'estimation comporte en outre une étape 57 d'estimation de la dérive fréquentielle affectant le signal utile détecté en fonction des spectres fréquentiels d'estimation $SE_j$ ($0 \le j \le N_{DER}-1$).

Dans des modes préférés de mise en œuvre, l'étape 57 d'estimation de la dérive fréquentielle affectant le signal utile détecté comporte la recherche d'un maximum global sur l'ensemble des spectres fréquentiels d'estimation $SE_j$ calculés pour ledit signal utile détecté. La dérive fréquentielle affectant ledit signal utile détecté, désignée par $\delta F_m$ ($0 \le m \le N_P-1$), est par exemple estimée comme étant la valeur $\alpha_j$ de dérive fréquentielle associée au spectre fréquentiel d'estimation $SE_j$ comportant ledit maximum global.

De préférence, le maximum global est recherché parmi les valeurs des spectres fréquentiels d'estimation $SE_j$ ($0 \le j \le N_{EST}-1$) obtenues dans une bande de fréquences de largeur prédéterminée, inférieure à la largeur de la bande fréquentielle de multiplexage, autour d'une fréquence théorique de réception du signal utile détecté. La fréquence de réception théorique du signal utile détecté correspond par exemple à une connaissance a priori de la fréquence de réception dudit signal utile détecté, ou encore, dans le cas illustré par la figure 3, à la fréquence de réception $F_m$ estimée au cours de la phase de détection (ou la fréquence nulle si le signal global est recalé en fréquences en fonction de la fréquence de réception $F_m$ estimée), etc. Pour des signaux utiles à bande étroite, la largeur fréquentielle de ladite bande de fréquences, à l'intérieur de laquelle le maximum global est recherché, est par exemple de l'ordre de 30 Hz.

B.4) Estimation de la fréquence de réception de signal utile détecté

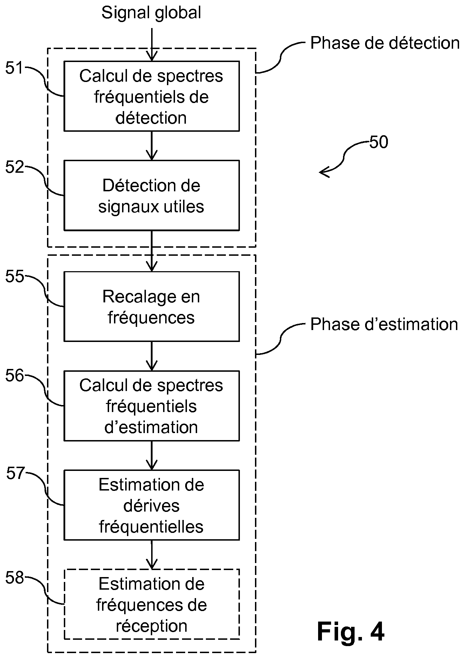

La figure 4 représente les principales étapes d'un mode particulier de mise en œuvre du procédé 50 de détection.

Tel qu'illustré par la figure 4, la phase d'estimation du procédé 50 de détection comporte, outre les étapes décrites précédemment en référence à la figure 2, une étape 58 d'estimation de la fréquence de réception $F_m$ du signal utile détecté en fonction des spectres fréquentiels d'estimation $SE_j$. Plus particulièrement, la fréquence de réception $F_m$ ($0 \le m \le N_P-1$) dudit signal utile détecté peut par exemple être estimée comme étant la fréquence discrète pour laquelle le maximum global, associé audit signal utile détecté, a été obtenu dans les spectres fréquentiels d'estimation $SE_j$.

Dans le cas où la fréquence de réception $F_m$ du signal utile détecté a déjà été estimée au cours de la phase de détection (étape 53 sur la figure 3), alors l'étape 58 d'estimation consiste en une mise à jour de ladite estimation de la fréquence de réception $F_m$. En effet, du fait que la fenêtre temporelle d'estimation est de durée supérieure à la durée de la fenêtre temporelle de détection, voire très supérieure à celle-ci (au moins un facteur cinq), la résolution fréquentielle, et donc la précision avec laquelle ladite fréquence de réception peut être estimée, est bien meilleure pour les spectres fréquentiels d'estimation $SE_j$ que pour les spectres fréquentiels de détection $SD_k$.

C) Module de détection

L'architecture matérielle du module 40 de détection utilisé pour mettre en œuvre le procédé 50 de détection est, dans des modes préférés de réalisation, optimisée pour minimiser la durée des calculs à effectuer.

De préférence, le module 40 de détection met en œuvre les différentes étapes du procédé 50 de détection de façon massivement parallèle pour optimiser l'utilisation des ressources matérielles dont dispose le module 40 de détection. Une telle approche permet soit de réduire le prix du module 40 de détection en réduisant sa taille par rapport à une solution classique, soit de pouvoir en augmenter la capacité de traitement.

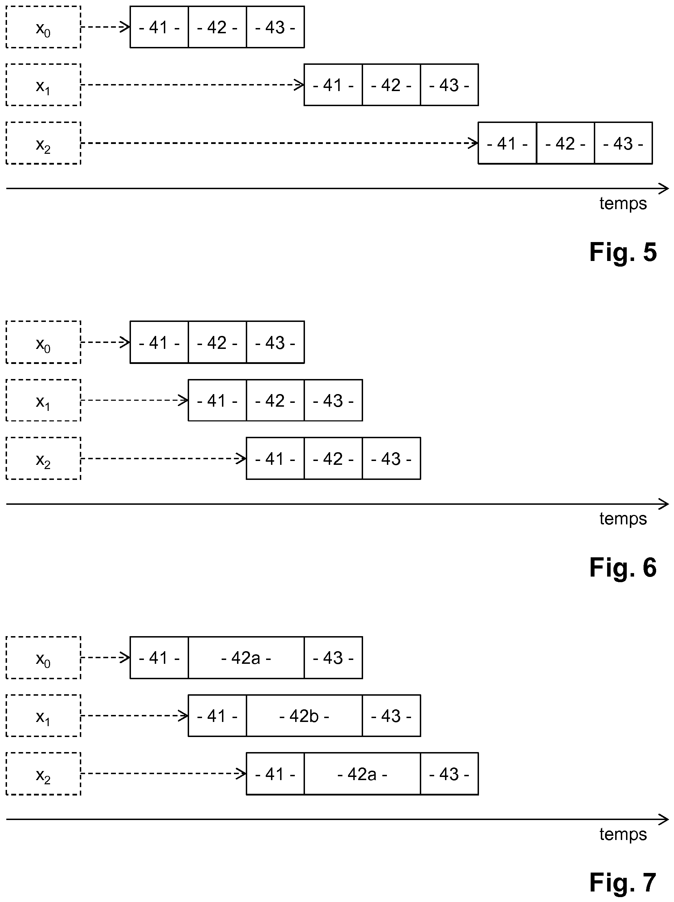

La figure 5 représente schématiquement une architecture de traitement séquentiel des vecteurs $x_k$ ($0 \leq k \leq N_{FEN}-1$) d'échantillons du signal global, associés aux $N_{FEN}$ positions de la fenêtre temporelle de détection. Dans l'exemple illustré par la figure 5, $N_{FEN}$ est considéré de manière non limitative comme étant égal à 3. Les traitements appliqués sur ces vecteurs $x_k$ illustrent une architecture de traitement séquentiel dans laquelle chaque vecteur se voit appliquer des traitements successifs qui réalisent les étapes du procédé 50 de détection. Ces traitements vont monopoliser différentes unités de calcul 41, 42, 43 du module 40 de détection. Chaque unité de calcul 41, 42, 43 réalise une fonction donnée (par exemple une FFT, un corrélateur, etc.) en utilisant des ressources matérielles du module 40 de détection. Une telle architecture de traitement séquentiel n'est pas très efficace car elle sous-utilise les unités de calcul 41, 42, 43.

La figure 6 illustre une architecture de traitement en pipeline, comme utilisée préférentiellement dans l'invention car améliorant l'utilisation des unités de calcul 41, 42, 43. Grâce à cette architecture de traitement en pipeline, les différents vecteurs $x_k$ sont traités en parallèle par le module 40 de détection. Dans cet exemple, l'unité de calcul 41 est exploitée à 100% de sa capacité dans l'architecture de traitement en pipeline (figure 6) alors qu'elle est seulement exploitée à 33% de sa capacité dans l'architecture de traitement séquentiel (figure 5).

En pratique, le temps de calcul pour chaque étape peut être différent car chaque étape peut nécessiter une quantité de calculs différente. Afin d'optimiser l'architecture de traitement en pipeline, la propriété de non-dépendance des données entre chaque étape est généralement exploitée pour paralléliser les unités de calcul des étapes les plus complexes.

En référence à la figure 7, dans un tel cas, la deuxième étape du traitement des données serait par exemple réalisée par deux unités de calcul 42a et 42b de la façon suivante : les vecteurs $x_0$ et $x_2$ utiliseraient par exemple l'unité de calcul 42a pour cette deuxième étape du procédé car s'effectuant en décalé dans le temps, tandis que le vecteur $x_1$ utiliserait par exemple l'unité de calcul 42b car cette opération se chevauche avec l'utilisation de l'unité de calcul 42a pour le traitement du vecteur $x_0$. Cela permet d'absorber les débits plus élevés en sortie de l'unité de calcul 41. Ce principe se généralise sur l'ensemble de l'architecture de traitement en pipeline pour toutes les étapes.

Le procédé 50 de détection permet de paralléliser efficacement les étapes de calcul critiques afin d'obtenir une architecture de traitement en pipeline optimisée car :

- pour la phase de détection, les flux de données (entrées/sorties) et les calculs des différentes étapes (étape 51 de calcul de spectres fréquentiels de détection, étape 52 de détection de signaux utiles, etc.) sont indépendants pour chaque position temporelle considérée de la fenêtre temporelle de détection,

- pour la phase d'estimation, les flux de données (entrées/sorties) et les calculs des différentes étapes (étape 55 de recalage en fréquences, étape 56 de calcul de spectres fréquentiels d'estimation, étape 57 d'estimation de dérives fréquentielles, etc.) sont indépendants pour chaque signal utile détecté.

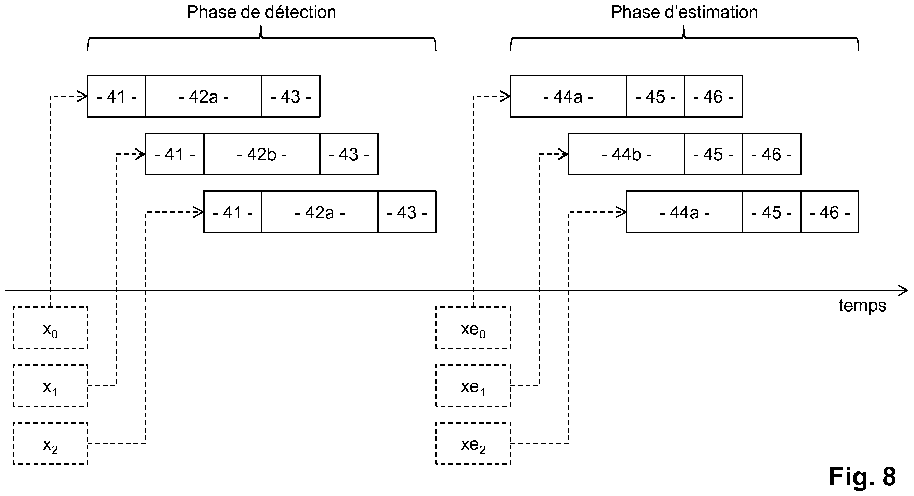

La figure 8 représente schématiquement l'architecture de traitement en pipeline utilisée pour mettre en œuvre le procédé 50 de détection. On retrouve les deux grandes phases du procédé 50 détection, à savoir la phase de détection et la phase d'estimation, chacune étant représentée par groupes de traitement s'effectuant successivement dans le temps. En effet, la phase d'estimation n'est effectuée que sur les $N_P$ signaux utiles détectés. Dans l'exemple illustré par la figure 8, $N_P$ est considéré de manière non limitative comme étant égal à 3.

La figure 8 illustre bien le fait que pour chaque phase de détection, une architecture de traitement en pipeline est utilisée pour effectuer en parallèle les différents traitements réalisés par les unités de calcul 41, 42a, 42b et 43, pour chacune des positions temporelles considérées pour la fenêtre temporelle de détection. Il en est de même pour chaque phase de d'estimation qui utilise une architecture de traitement en pipeline pour effectuer en parallèle les différents traitements réalisés par des unités de calcul 44a, 44b, 45 et 46, pour chaque signal utile détecté.

Le principe d'exploitation du parallélisme du procédé 50 de détection peut être également appliqué pour réaliser en parallèle les phases de détection et d'estimation sur des jeux de données différents, correspondant par exemple à des signaux globaux issus de bandes fréquentielles différentes.

Ainsi, la structure du procédé 50 de détection permet de mettre en œuvre une architecture de traitement massivement parallèle dans le module 40 de détection afin de maximiser la réutilisation des ressources matérielles.

Les différents degrés de parallélisme présentés précédemment peuvent être exploités pour faire les meilleurs compromis de conception du module 40 de détection (taille, consommation, vitesse d'exécution). Cette exploitation efficace est rendue possible car la dimension temporelle et la dimension fréquentielle sont traitées indépendamment, facilitant une architecture de traitement en pipeline pour l'exploitation du parallélisme en convertissant un problème à 2 dimensions, en 2 problèmes à 1 dimension.

De plus, pour répondre à des contextes d'utilisation différents, fonction de la plage/résolution suivant la dimension temporelle (phase détection) et de la plage/résolution suivant la dimension fréquentielle (phase d'estimation), l'évolutivité de l'architecture est également simple à mettre en œuvre car les degrés de parallélisme sont directement fonction du nombre $N_{FEN}$ de positions temporelles considérées et du nombre $N_P$ de signaux utiles à détecter.

Enfin, sans perte de généralité, les traitements peuvent être appliqués soit tous au sein d'un même processeur du module 40 de détection, soit répartis sur plusieurs processeurs dudit module 40 de détection, en fonction des exigences de performances requises par le système de détection.

## Revendications

1. Procédé (50) de détection de signaux utiles dans un signal global, lesdits signaux utiles étant émis par différents terminaux (10) dans une bande fréquentielle de multiplexage, chaque signal utile pouvant être affecté d'une dérive fréquentielle, le signal global correspondant aux signaux radioélectriques reçus dans la bande fréquentielle de multiplexage, **caractérisé en ce qu'il** comporte une phase de détection comportant :

   - pour plusieurs positions d'une fenêtre temporelle de détection par rapport au signal global : un calcul (51) d'un spectre fréquentiel de détection du signal global sur chaque fenêtre temporelle de détection considérée,
   - une détection (52) de signaux utiles dans le signal global en fonction des spectres fréquentiels de détection,

   et une phase d'estimation comportant, pour chaque signal utile détecté :

   - pour plusieurs valeurs de dérive fréquentielle : un recalage en fréquences (55) du signal global en fonction de la valeur de dérive fréquentielle considérée,
   - un calcul (56) d'un spectre fréquentiel d'estimation du signal global pour chaque valeur de dérive fréquentielle sur une fenêtre temporelle d'estimation comportant au moins une partie dudit signal utile détecté, de durée supérieure à la durée de la fenêtre temporelle de détection,
   - une estimation (57) de la dérive fréquentielle affectant ledit signal utile détecté en fonction des spectres fréquentiels d'estimation.

2. Procédé (50) selon la revendication 1, dans lequel, chaque signal utile comportant un motif de détection :

   - le calcul (51) de spectre fréquentiel de détection comporte, pour chaque fenêtre temporelle de détection, une combinaison du signal global avec un motif de détection de référence positionné au niveau de la fenêtre temporelle de détection considérée,
   - le calcul (56) de spectre fréquentiel d'estimation comporte, pour chaque valeur de dérive fréquentielle, une combinaison du signal global avec le motif de détection de référence positionné au niveau de la fenêtre temporelle d'estimation.

3. Procédé (50) selon la revendication 2, dans lequel la combinaison du signal global avec le motif de détection de référence comporte une corrélation dudit signal global avec ledit motif de détection de référence.

4. Procédé (50) selon l'une des revendications précédentes, dans lequel la durée de la fenêtre temporelle de détection est inférieure à la durée du motif de détection.

5. Procédé (50) selon l'une des revendications précédentes, comportant :

   - au cours de la phase de détection : une estimation (53) d'une fréquence de réception de chaque signal utile détecté dans la bande de multiplexage, en fonction des spectres fréquentiels de détection,
   - au cours de la phase d'estimation, pour chaque signal utile détecté : le recalage en fréquences (55) du signal global en fonction en outre de la fréquence de réception estimée dudit signal utile détecté.

6. Procédé (50) selon l'une des revendications précédentes, comportant, au cours de la phase d'estimation, une estimation (58) d'une fréquence de réception de chaque signal utile détecté dans la bande de multiplexage, en fonction des spectres fréquentiels d'estimation.

7. Procédé (50) selon l'une des revendications précédentes, dans lequel la détection (52) de signaux utiles comporte la recherche de maxima locaux dans les spectres fréquentiels de détection, un signal utile étant considéré comme détecté pour un maximum local si ledit maximum local vérifie un critère prédéterminé de détection.

8. Procédé (50) selon l'une des revendications précédentes, dans lequel l'estimation (57) de dérive fréquentielle affectant l'un des signaux utiles détectés comporte la recherche d'un maximum global dans les spectres fréquentiels d'estimation calculés pour ledit signal utile détecté.

9. Procédé (50) selon la revendication 8, dans lequel, au cours de l'estimation (57) de dérive fréquentielle, le maximum global est recherché parmi les valeurs des spectres fréquentiels d'estimation obtenues dans une bande de fréquences de largeur prédéterminée autour d'une fréquence théorique de réception du signal utile détecté considéré.

10. Procédé (50) selon l'une des revendications précédentes, comportant une estimation du nombre de signaux utiles à détecter dans le signal global, et dans lequel la détection (52) de signaux utiles est effectuée en fonction dudit nombre estimé de signaux utiles à détecter.

11. Procédé (50) selon l'une des revendications précédentes, comportant une estimation d'une plage de valeurs possibles pour la dérive fréquentielle, les valeurs de dérive fréquentielle considérées au cours de la phase d'estimation étant comprises dans ladite plage de valeurs possibles.

12. Produit programme d'ordinateur **caractérisé en ce qu'**il comporte un ensemble d'instructions de code de programme qui, lorsqu'elles sont exécutées par un processeur, configurent ledit processeur pour mettre en œuvre un procédé (50) de détection de signaux utiles dans un signal global selon l'une des revendications précédentes.

13. Module (40) de détection de signaux utiles dans un signal global **caractérisé en ce qu'**il comporte des moyens configurés pour mettre en œuvre un procédé (50) selon l'une des revendications 1 à 11.

14. Module (40) selon la revendication 13, comportant une architecture de traitement de type pipeline.

15. Module (40) selon la revendication 14, comportant un premier ensemble d'unités de calcul (41-43) utilisées uniquement pour la phase de détection et un second ensemble d'unités de calcul (44-46) utilisées uniquement pour la phase d'estimation

16. Système de détection de signaux utiles dans un signal global, comportant une antenne de réception du signal global embarquée dans un engin spatial (30) ou aérien, **caractérisé en ce qu'**il comporte un module (40) de détection selon l'une des revendications 13 à 15.

17. Système selon la revendication 16, dans lequel le module (40) de détection est embarqué dans l'engin spatial (30) ou aérien.

**Patentansprüche**

1. Verfahren (50) zum Erkennen von Nutzsignalen in einem Gesamtsignal, wobei die Nutzsignale von unterschiedlichen Endgeräten (10) in einem Multiplexing-Frequenzband gesendet werden, wobei jedes Nutzsignal von einer Frequenzdrift betroffen sein kann, wobei das Gesamtsignal den im Multiplexing-Frequenzband empfangenen Funksignalen entspricht, **dadurch gekennzeichnet, dass** es eine Erkennungsphase umfasst, welche umfasst:

- für mehrere Positionen eines Erkennungszeitfensters in Bezug auf das Gesamtsignal: ein Berechnen (51) eines Erkennungsfrequenzspektrums des Gesamtsignals über jedes betreffende Erkennungszeitfenster,
- ein Erkennen (52) von Nutzsignalen im Gesamtsignal in Abhängigkeit von den Erkennungsfrequenzspektren,

und eine Schätzphase, die für jedes erkannte Nutzsignal umfasst:

- für mehrere Frequenzdriftwerte: eine Frequenzverschiebung (55) des Gesamtsignals in Abhängigkeit vom betreffenden Frequenzdriftwert,
- ein Berechnen (56) eines Schätzfrequenzspektrums des Gesamtsignals für jeden Frequenzdriftwert über ein mindestens einen Teil des erkannten Nutzsignals umfassendes Schätzzeitfenster, das von größerer Dauer ist als der Dauer des Erkennungszeitfensters,
- ein Schätzen (57) der Frequenzdrift, die das erkannte Nutzsignal betrifft, in Abhängigkeit von den Schätzfrequenzspektren.

2. Verfahren (50) nach Anspruch 1, wobei, wenn jedes Nutzsignal ein Erkennungsmuster umfasst:

- das Berechnen (51) des Erkennungsfrequenzspektrums für jedes Erkennungszeitfenster ein Kombinieren des Gesamtsignals mit einem Referenzerkennungsmuster umfasst, das im Bereich des betreffenden Erkennungszeitfensters positioniert ist,
- das Berechnen (56) des Schätzfrequenzspektrums für jeden Frequenzdriftwert ein Kombinieren des Gesamtsignals mit dem Referenzerkennungsmuster umfasst, das im Bereich des Schätzzeitfensters positioniert ist.

3. Verfahren (50) nach Anspruch 2, wobei das Kombinieren des Gesamtsignals mit dem Referenzerkennungsmuster ein Korrelieren des Gesamtsignals mit dem Referenzerkennungsmuster umfasst.

4. Verfahren (50) nach einem der vorstehenden Ansprüche, wobei die Dauer des Erkennungszeitfensters kleiner ist als die Dauer des Erkennungsmusters.

5. Verfahren (50) nach einem der vorstehenden Ansprüche, umfassend:

- während der Erkennungsphase: ein Schätzen (53) einer Empfangsfrequenz jedes im Multiplexing-Band erkannten Nutzsignals in Abhängigkeit von den Erkennungsfrequenzspektren,
- während der Schätzphase für jedes erkannte Nutzsignal: die Frequenzverschiebung (55) des Gesamtsignals weiter in Abhängigkeit von der geschätzten Empfangsfrequenz des erkannten Nutzsignals.

6. Verfahren (50) nach einem der vorstehenden Ansprüche, das während der Schätzphase ein Schätzen (58) einer Empfangsfrequenz jedes im Multiplexing-Band erkannten Nutzsignals in Abhängigkeit von den Schätzfrequenzspektren umfasst.

7. Verfahren (50) nach einem der vorstehenden Ansprüche, wobei das Erkennen (52) von Nutzsignalen das Suchen von lokalen Maxima in den Erkennungsfrequenzspektren umfasst, wobei ein Nutzsignal als für ein lokales Maximum erkannt erachtet wird, wenn das lokale Maximum ein vorbestimmtes Erkennungskriterium erfüllt.

8. Verfahren (50) nach einem der vorstehenden Ansprüche, wobei das Schätzen (57) der Frequenzdrift, die eines der erkannten Nutzsignale betrifft, das Suchen eines Gesamtmaximums in den für das erkannte Nutzsignal berechneten Schätzfrequenzspektren umfasst.

9. Verfahren (50) nach Anspruch 8, wobei während des Schätzens (57) der Frequenzdrift das Gesamtmaximum unter den Werten der Schätzfrequenzspektren gesucht wird, die in einem Frequenzband einer vorbestimmten Breite um eine theoretische Empfangsfrequenz des betreffenden erkannten Nutzsignals herum erhalten werden.

10. Verfahren (50) nach einem der vorstehenden Ansprüche, das ein Schätzen der Anzahl von im Gesamtsignal zu erkennenden Nutzsignalen umfasst, und wobei das Erkennen (52) von Nutzsignalen in Abhängigkeit von der geschätzten Anzahl von zu erkennenden Nutzsignalen durchgeführt wird.

11. Verfahren (50) nach einem der vorstehenden Ansprüche, das ein Schätzen eines Bereichs von für die Frequenzdrift möglichen Werten umfasst, wobei die Frequenzdriftwerte, die während der Schätzphase berücksichtigt werden, im möglichen Wertebereich liegen.

12. Computerprogrammprodukt, **dadurch gekennzeichnet, dass** es einen Satz von Programmcodeanweisungen umfasst, die, wenn sie von einem Prozessor ausgeführt werden, den Prozessor dafür konfigurieren, ein Verfahren (50) zum Erkennen von Nutzsignalen in einem Gesamtsignal nach einem der vorstehenden Ansprüche zu implementieren.

13. Modul (40) zum Erkennen von Nutzsignalen in einem Gesamtsignal, **dadurch gekennzeichnet, dass** es Mittel umfasst, die dafür konfiguriert sind, ein Verfahren (50) nach einem der Ansprüche 1 bis 11 zu implementieren.

14. Modul (40) nach Anspruch 13, das eine Verarbeitungsarchitektur vom Typ Pipeline umfasst.

15. Modul (40) nach Anspruch 14, das einen ersten Satz von Recheneinheiten (41-43) umfasst, die nur für die Erkennungsphase verwendet werden, und einen zweiten Satz von Recheneinheiten (44-46), die nur für die Schätzphase verwendet werden.

16. System zum Erkennen von Nutzsignalen in einem Gesamtsignal, das eine Antenne zum Empfangen des Gesamtsignals umfasst, die in einem Luft- oder Raumfahrzeug (30) eingebettet ist, **dadurch gekennzeichnet, dass** es ein Erkennungsmodul (40) nach einem der Ansprüche 13 bis 15 umfasst.

17. System nach Anspruch 16, wobei das Erkennungsmodul (40) in das Luft- oder Raumfahrzeug (30) eingebettet ist.

**Claims**

1. Method (50) for detecting useful signals in an overall signal, said useful signals being emitted by different terminals (10) in a multiplexing frequency band, each of which useful signals can be affected by a frequency drift, the overall signal corresponding to the radio-frequency signals received in the multiplexing frequency band, **characterized in that** it comprises a detection phase comprising:

   - for a plurality of positions of a detection time window relative to the overall signal: calculating (51) a detection frequency spectrum of the overall signal for each detection time window being considered,
   - detecting (52) useful signals in the overall signal as a function of the detection frequency spectra,

   and an estimation phase comprising, for each useful signal detected:

   - for a plurality of frequency drift values: readjusting (55) the frequency of the overall signal as a function of the frequency drift value being considered,
   - calculating (56) an estimation frequency spectrum of the overall signal for each frequency drift value over an estimation time window comprising at least part of said useful signal detected, and of a duration that is longer than that of the detection time window,
- estimating (57) the frequency drift affecting said useful signal detected as a function of the estimation frequency spectra.

2. Method (50) according to claim 1 wherein, each useful signal comprising a detection pattern:

   - the calculation (51) of the detection frequency spectrum comprises, for each detection time window, a combination of the overall signal and a reference detection pattern positioned at the level of the detection time window considered,
   - the calculation (56) of the estimation frequency spectrum comprises, for each frequency drift value, a combination of the overall signal and the reference detection pattern positioned at the level of the estimation time window.

3. Method (50) according to claim 2, wherein the combination of the overall signal and the reference detection pattern comprises a correlation of said overall signal with said reference detection pattern.

4. Method (50) according to one of the previous claims, wherein the duration of the detection time window is shorter than the duration of the detection pattern.

5. Method (50) according to one of the previous claims, comprising:

   - during the detection phase: estimating (53) a receiving frequency for each useful signal detected in the multiplexing band, as a function of the detection frequency spectra,
   - during the estimation phase, for each useful signal detected: readjusting (55) the frequency of the overall signal also as a function of the estimated receiving frequency for said useful signal detected.

6. Method (50) according to one of the previous claims, comprising, during the estimation phase, estimating (58) a receiving frequency for each useful signal detected in the multiplexing band, as a function of the estimation frequency spectra.

7. Method (50) according to one of the previous claims, wherein the detection (52) of useful signals comprises searching for local maxima in the detection frequency spectra, whereby a useful signal is considered to have been detected for a local maximum if said local maximum satisfies a predetermined detection criterion.

8. Method (50) according to one of the previous claims, wherein the estimation (57) of the frequency drift affecting one of the useful signals detected comprises searching for an overall maximum in the estimated frequency spectra calculated for said useful signal detected.

9. Method (50) according to claim 8, wherein, during the estimation (57) of the frequency drift, the overall maximum is sought from among the values of the estimation frequency spectra obtained in a frequency band of a predetermined bandwidth about a theoretical receiving frequency for the considered useful signal detected.

10. Method (50) according to one of the previous claims, comprising estimating the number of useful signals to be detected in the overall signal, and wherein the detection (52) of useful signals is carried out as a function of said estimated number of useful signals to be detected.

11. Method (50) according to one of the previous claims, comprising estimating a range of possible values for the frequency drift, whereby the frequency drift values considered during the estimation phase lie in said range of possible values.

12. Computer program product, **characterized in that** it comprises a set of program code instructions which, when executed by a processor, configure said processor to implement a method (50) for detecting useful signals in an overall signal according to one of the previous claims.

13. Module (40) for detecting useful signals in an overall signal, **characterized in that** it comprises means configured to implement a method (50) according to one of claims 1 to 11.

14. Module (40) according to claim 13, comprising a pipeline-type processing architecture.

15. Module (40) according to claim 14, comprising a first set of arithmetic units (41-43) used solely for the detection phase and a second set of arithmetic units (44-46) used solely for the estimation phase.

16. System for detecting useful signals in an overall signal, comprising an antenna for receiving the overall signal on board a spacecraft (30) or aircraft, **characterized in that** it comprises a detection module (40) according to one of claims 13 to 15.

17. System according to claim 16, wherein the detection module (40) is on board the spacecraft (30) or aircraft.

Fig. 1

Fig. 2

Signal global

51 — Calcul de spectres fréquentiels de détection

Phase de détection

52 — Détection de signaux utiles

-50

53 — Estimation de fréquences de réception

55 — Recalage en fréquences

Phase d'estimation

56 — Calcul de spectres fréquentiels d'estimation

57 — Estimation de dérives fréquentielles

**Fig. 3**

Signal global

51 — Calcul de spectres fréquentiels de détection

Phase de détection

52 — Détection de signaux utiles

50

55 — Recalage en fréquences

Phase d'estimation

56 — Calcul de spectres fréquentiels d'estimation

57 — Estimation de dérives fréquentielles

58 — Estimation de fréquences de réception

**Fig. 4**

$x_0$ → - 41 - | - 42 - | - 43 -

$x_1$ → - 41 - | - 42 - | - 43 -

$x_2$ → - 41 - | - 42 - | - 43 -

temps

**Fig. 5**

$x_0$ → - 41 - | - 42 - | - 43 -

$x_1$ → - 41 - | - 42 - | - 43 -

$x_2$ → - 41 - | - 42 - | - 43 -

temps

**Fig. 6**

$x_0$ → - 41 - | - 42a - | - 43 -

$x_1$ → - 41 - | - 42b - | - 43 -

$x_2$ → - 41 - | - 42a - | - 43 -

temps

**Fig. 7**

Fig. 8

EP 3 485 626 B1

**EP 3 485 626 B1**

## RÉFÉRENCES CITÉES DANS LA DESCRIPTION

### Documents brevets cités dans la description

- WO 2014006351 A